# EUROPÄISCHE PATENTSCHRIFT

(11) **EP 0 916 138 B1**
(45) Veröffentlichungstag und Bekanntmachung des Hinweises auf die Patenterteilung: **26.09.2001**
(21) Anmeldenummer: 97932749.1
(22) Anmeldetag: 08.07.1997
(51) Int. Cl.: G11C 11/56, H01L 29/792

(54) **VERFAHREN ZUM BETRIEB EINER SPEICHERZELLENANORDNUNG**
METHOD OF OPERATING A STORAGE CELL ARRANGEMENT
PROCEDE DE FONCTIONNEMENT D'UN ENSEMBLE DE CELLULES MEMOIRE

(30) Priorität: 01.08.1996 DE 19631154
(43) Veröffentlichungstag der Anmeldung: 19.05.1999
(73) Patentinhaber: Infineon Technologies AG, 81669 München (DE)
(72) Erfinder: REISINGER, Hans, D-82031 Grünwald (DE)
(74) Vertreter: Zedlitz, Peter, Dipl.-Inf.
(86) Internationale Anmeldenummer: DE9701432
(87) Internationale Veröffentlichungsnummer: WO9806101

(56) Entgegenhaltungen:
- EP-A- 0 311 773
- EP-A- 0 692 825
- US-A- 3 979 582
- US-A- 4 057 788
- US-A- 5 311 049
- US-A- 5 436 481
- "three state MNOS memory array" IBM TECHNICAL DISCLOSURE BULLETIN., Bd. 18, Nr. 12, Juni 1976, NEW YORK US, Seiten 4192-4193, XP002043699
- PATENT ABSTRACTS OF JAPAN vol. 7, no. 206 (P-222), 10.September 1983 & JP 58 102394 A (CITIZEN TOKEI)

## Beschreibung

Zur dauerhaften Speicherung von Daten werden üblicherweise nichtflüchtige EEPROM-Zellen verwendet. Zur Realisierung von EEPROM-Zellen sind unterschiedliche Technologien vorgeschlagen worden (siehe zum Beispiel Lai et al, IEDM Tech. Dig., 1986, Seiten 580 - 583).

Einerseits werden in den sogenannten SONOS- oder MNOS-Zellen als Speicherzellen spezielle MOS-Transistoren verwendet. Der MOS-Transistor umfaßt ein Gatedielektrikum, das mindestens eine Siliziumnitridschicht unterhalb der Gateelektrode und eine Siliziumoxidschicht zwischen der Siliziumnitridschicht und dem Kanalbereich umfaßt. Zur Speicherung der Information werden Ladungsträger in der Siliziumnitridschicht gespeichert.

In SONOS-Zellen beträgt die Dicke der Siliziumoxidschicht maximal 2,2 nm. Die Dicke der Siliziumnitridschicht beträgt in modernen SONOS-Speichern üblicherweise etwa 10 nm. Zwischen der Siliziumnitridschicht und der Gateelektrode ist meist eine weitere Siliziumoxidschicht vorgesehen, die eine Dicke von 3 bis 4 nm aufweist. Diese nichtflüchtigen Speicherzellen sind elektrisch schreib- und löschbar. Beim Schreibvorgang wird an die Gateelektrode eine solche Spannung angelegt, daß Ladungsträger aus dem Substrat durch die maximal 2,2 nm dicke Siliziumoxidschicht in die Siliziumnitridschicht tunneln. Zum Löschen wird die Gateelektrode so beschaltet, daß die in der Siliziumnitridschicht gespeicherten Ladungsträger durch die 2 nm dicke Siliziumoxidschicht in den Kanalbereich tunneln und aus dem Kanalbereich Ladungsträger vom entgegengesetzten Leitfähigkeitstyp durch die Siliziumoxidschicht in die Siliziumnitridschicht tunneln.

SONOS-Zellen weisen eine Zeit für den Datenerhalt von ≤ 10 Jahren auf. Diese Zeit ist für viele Anwendungen, zum Beispiel für die Speicherung von Daten in Computern, zu kurz.

Als Alternative zu den SONOS-Zellen werden EEPROM-Zellen mit floating gate verwendet. Diese sind für Anwendungen, in denen längere Zeiten für den Datenerhalt gefordert werden, geeignet. In diesen Speicherzellen ist zwischen einer Kontrollgateelektrode und dem Kanalbereich des MOS-Transistors eine Floating Gate Elektrode angeordnet, die vollständig von dielektrischem Material umgeben ist. Auf der Floating Gate Elektrode wird die Information in Form von Ladungsträgern gespeichert. Diese Speicherzellen, die auch als FLOTOX-Zellen bezeichnet werden, sind elektrisch schreib- und löschbar. Dazu wird die Steuergateelektrode mit einem solchen Potential verbunden, daß Ladungsträger aus dem Kanalbereich auf die Floating Gate Elektrode fließen (schreiben) bzw. Ladungsträger von der Floating Gate Elektrode in den Kanalbereich fließen (löschen). Diese FLOTOX-Zellen weisen Zeiten für den Datenerhalt < als 150 Jahre auf.

Im Vergleich zu den SONOS-Zellen sind sie jedoch kompliziert im Aufbau. Ferner ist der Platzbedarf der FLOTOX-Zellen im Vergleich zu den SONOS-Zellen größer, da die Steuergateelektrode die Floating Gate Elektrode seitlich überlappen muß. Schließlich ist die sogenannte Radiation hardness von FLOTOX-Zellen begrenzt. Unter Radiation hardness wird die Unempfindlichkeit der gespeicherten Ladung gegenüber äußeren Strahlungsquellen und/oder elektromagnetischen Feldern bezeichnet.

Zur Erhöhung der Speicherdichte in FLOTOX-Zellen ist vorgeschlagen worden (siehe zum Beispiel Lai et al, IEDM Tech. Dig., 1986, Seiten 580 - 583), Informationen im Sinne einer Mehrwertlogik zu speichern. Dabei werden mehr als 3 logische Werte dadurch gespeichert, daß jedem logischen Wert ein Einsatzspannungswert des MOS-Transistors eindeutig zugeordnet wird. Bei der Programmierung werden abhängig von dem zu speichernden logischen Wert durch Injektion unterschiedlicher Ladungsmengen die verschiedenen Einsatzspannungswerte eingestellt.

Der Erfindung liegt das Problem zugrunde, ein Verfahren zum Betrieb einer Speicherzellenanordnung anzugeben, bei dem eine gegenüber dem Stand der Technik erhöhte Speicherdichte erzielt wird und bei dem eine Zeit für den Datenerhalt von mindestens 150 Jahren erreicht wird.

Dieses Problem wird erfindungsgemäß gelöst durch ein Verfahren nach Anspruch 1. Weitere Ausgestaltungen gehen aus den Unteransprüchen hervor.

In dem erfindungsgemäßen Verfahren wird eine Speicherzellenanordnung verwendet, die als Speicherzellen jeweils einen MOS-Transistor mit Sourcegebiet, Kanalbereich, Draingebiet, Gatedielektrikum und Gateelektrode umfaßt, der als Gatedielektrikum eine dielektrische Dreifachschicht aufweist. Die dielektrische Dreifachschicht umfaßt eine erste Siliziumoxidschicht, eine Siliziumnitridschicht und eine zweite Siliziumoxidschicht. Die Siliziumnitridschicht ist zwischen den beiden Siliziumoxidschichten angeordnet. Die erste Siliziumoxidschicht und die zweite Siliziumoxidschicht weisen jeweils eine Dicke von mindestens 3 nm auf.

Von konventionellen SONOS-Zellen unterscheidet sich die in dem erfindungsgemäßen Verfahren verwendete Speicherzelle dadurch, daß die erste Siliziumoxidschicht, die zwischen dem Kanalbereich des MOS-Transistors und der Siliziumnitridschicht angeordnet ist, eine Dicke von mindestens 3 nm aufweist. In konventionellen SONOS-Zellen beträgt diese Dicke maximal 2,2 nm.

In dem erfindungsgemäßen Verfahren wird die Erkenntnis ausgenutzt, daß in konventionellen SONOS-Zellen der Ladungstransport durch die erste Siliziumoxidschicht hauptsächlich über direktes Tunneln und modifiziertes Fowler-Nordheim-Tunneln erfolgt. Die Tunnelwahrscheinlichkeit für direktes Tunneln und modifiziertes Fowler-Nordheim-Tunneln und damit die Stromstärke für den Ladungstransport durch diese Tunnelmechanismen hängt hauptsächlich von der Dicke der Tunnelbarriere, das heißt der Dicke der ersten Siliziumoxidschicht, und vom elektrischen Feld ab. Da in konventionellen SONOS-Zellen die erste Siliziumoxidschicht maximal 2,2 nm und die zweite Siliziumoxidschicht 3 bis 4 nm dick ist, überwiegt bei elektrischen Feldern unter 10 MV/cm stets der Strom durch direktes Tunneln durch die erste Siliziumoxidschicht. Über diesen direkten Tunnelstrom erfolgt sowohl das Schreiben als auch das Löschen der Information, durch entsprechende Beschaltung der Gateelektrode.

Bei konventionellen SONOS-Zellen fließt auch ohne Beschaltung der Gateelektrode ein Tunnelstrom, der auf direktes Tunneln zurückgeht, durch die erste Siliziumoxidschicht von der Siliziumnitridschicht zum Kanalbereich. Es wurde festgestellt, daß dieser direkte Tunnelstrom für die Zeit für den Datenerhalt bestimmend ist.

Weiterhin wird in dem erfindungsgemäßen Verfahren ausgenutzt, daß die Tunnelwahrscheinlichkeit für direktes Tunneln mit zunehmender Dicke der ersten Siliziumoxidschicht stark abnimmt und bei einer Dicke von mindestens 3 nm sehr klein wird. Bei einer Dicke von 3 nm beträgt die Tunnelwahrscheinlichkeit für direktes Tunneln etwa einen Faktor 10⁶ weniger als bei 2 nm.

Da in der Speicherzelle, die in dem erfindungsgemäßen Verfahren eingesetzt wird, die erste Siliziumoxidschicht und die zweite Siliziumoxidschicht jeweils mindestens 3 nm dick sind, wird in dieser Speicherzelle ein Ladungsträgertransport aus der Siliziumnitridschicht zur Gateelektrode oder zum Kanalbereich durch direktes Tunneln weitgehend vermieden. Das heißt, in der Siliziumnitridschicht gespeicherte Ladung bleibt praktisch unbegrenzt erhalten. Die Zeit für den Datenerhalt ist in dieser Speicherzelle daher deutlich größer als in konventionellen SONOS-Zellen. Sie beträgt > 1000 Jahre anstelle von 10 Jahren bei konventionellen SONOS-Zellen.

Es wurde beobachtet, daß die Einsatzspannung der MOS-Transistoren bei den in dem erfindungsgemäßen Verfahren verwendeten Speicherzellen mit der Zeit zu höheren Werten driftet. Dieser Verlauf der Einsatzspannung zeigt, daß es keinen Verlust von in der Siliziumnitridschicht gespeicherter Ladung gibt. Vielmehr kommt es zu einer Wanderung von der in der Siliziumnitridschicht gespeicherten Ladung in Richtung Substrat.

Da die Dicken der ersten Siliziumoxidschicht und der zweiten Siliziumoxidschicht in der in dem erfindungsgemäßen Verfahren verwendeten Speicherzelle jeweils mindestens 3 nm betragen, ist die Tunnelwahrscheinlichkeit für direktes Tunneln von Ladungsträgern durch die beiden Siliziumoxidschichten sehr klein. Ein Ladungsträgertransport durch die erste Siliziumoxidschicht bzw. zweite Siliziumoxidschicht findet nur durch Fowler-Nordheim-Tunneln statt. Die Stromstärke des Ladungsträgertransports durch Fowler-Nordheim-Tunneln hängt nur von der Stärke des anliegenden elektrischen Feldes ab. Sie ist nicht explizit abhängig von der Dicke der Tunnelbarriere, das heißt der Dicke der ersten Siliziumoxidschicht bzw. zweiten Siliziumoxidschicht.

In dem erfindungsgemäßen Verfahren werden verschiedenen logischen Werten verschiedene Einsatzspannungspegel des MOS-Transistors zugeordnet. Wegen der langen Zeit für den Datenerhalt sind diese Einsatzspannungspegel sehr stabil und es können daher viele Einsatzspannungspegel pro Volt vorgesehen werden.

Die Einsatzspannungspegel können gleiche oder unterschiedliche Abstände von einander haben. Da die zeitliche Drift der Einsatzspannungspegel für größere Einsatzspannungspegel größer ist als für kleinere, ist es vorteilhaft, die Einsatzspannungspegel so zu definieren, daß der Abstand zwischen benachbarten Einsatzspannungspegeln mit zunehmendem Einsatzspannungspegel zunimmt.

Gemäß einer Ausführungsform weist die Speicherzelle eine Gateelektrode aus n-dotiertem Silizium, Metall oder einem Metallsilizid auf. In dieser Speicherzelle dominiert das Fowler-Nordheim-Tunneln von Elektronen den Ladungsträgertransport unabhängig von der Polarität des anliegenden Feldes. Das heißt, sowohl bei Anliegen einer positiven Spannung als auch bei Anliegen einer negativen Spannung an der Gateelektrode kommt es zum Fowler-Nordheim-Tunneln von Elektronen in die Siliziumnitridschicht. Liegt an der Gateelektrode eine positive Spannung an, so tunneln Elektronen aus dem Kanalbereich durch die erste Siliziumoxidschicht in die Siliziumnitridschicht. Liegt dagegen an der Gateelektrode eine negative Spannung an, so tunneln Elektronen durch Fowler-Nordheim-Tunneln aus der Gateelektrode durch die zweite Siliziumoxidschicht in die Siliziumnitridschicht.

Da in dieser Speicherzelle unabhängig von der anliegenden Polarität an der Gateelektrode durch Fowler-Nordheim-Tunneln Elektronen in die Siliziumnitridschicht transportiert werden, können Elektronen, die einmal in die Siliziumnitridschicht transportiert worden sind, nicht wieder entfernt werden. Die Speicherzelle weist daher eine sehr große Zeit für den Datenerhalt auf. Die Einsatzspannungspegel sind über die Zeit so stabil, daß in einem Spannungsfenster von 4 Volt 64 Einsatzspannungspegel vorgesehen werden können.

Vorzugsweise liegt in dieser Speicherzelle die Differenz der Dicken der ersten Siliziumoxidschicht und der zweiten Siliziumoxidschicht im Bereich zwischen 0,5 nm und 1 nm. Die geringere der Dicken der ersten Siliziumoxidschicht und der zweiten Siliziumoxidschicht liegt im Bereich zwischen 3 nm und 6 nm. Die Dicke der Siliziumnitridschicht beträgt mindestens 5 nm.

In einer anderen Ausführungsform der Erfindung wird eine Speicherzelle verwendet, die eine Gateelektrode aus p⁺-dotiertem Silizium aufweist. Im Vergleich zu n-dotiertem Silizium oder Metall, das als Gateelektrode in der ersten Ausführungsform verwendet wird, ist im Idealfall durch die p⁺-Dotierung die Besetzungswahrscheinlichkeit von elektronischen zuständen in der Gateelektrode um etwa den Faktor 10²⁰ reduziert. Daher kann in der Speicherzelle gespeicherte Information elektrisch gelöscht werden. Beim Löschvorgang können wegen der reduzierten Besetzungswahrscheinlichkeit von elektronischen Zuständen keine Elektronen aus der Gateelektrode in die Siliziumnitridschicht tunneln. Der Löschvorgang der erfindungsgemäßen Speicherzelle erfolgt daher über Tunneln von Löchern aus dem Kanalbereich durch die erste Siliziumoxidschicht in die Siliziumnitridschicht und durch Tunneln von Elektronen aus der Siliziumnitridschicht in den Kanalbereich. Bei Speicherzellen mit elektronenreichen Gateelektroden tunneln zusätzlich Elektronen aus der Gateelektrode in die Siliziumnitridschicht, die beim Löschvorgang ebenfalls neutralisiert werden müssen. Dieser Elektronenstrom wird in der hier verwendeten Speicherzelle dadurch unterdrückt, daß die Zahl der Elektronen in der Gateelektrode durch die Verwendung von p⁺-dotiertem Silizium reduziert ist. Die Zeit für den Löschvorgang ist in dieser Speicherzelle im Vergleich zu Speicherzellen mit elektronenreichen Gateelektroden um einen Faktor von ca. 10⁵ reduziert.

Allerdings ist der Ladungsverlust aus der Siliziumnitridschicht durch direktes Tunneln in diesem Fall im Vergleich zu Speicherzellen mit elektronenreichen Gateelektroden um mehrere Größenordnungen höher. Daher können nur eine geringere Anzahl Einsatzspannungspegel pro Volt vorgesehen werden. Bei Löschzeiten in der Größenordnung von 1 Sekunde sind in einem Fenster von 4 Volt 4 bis 8 Einsatzspannungspegel möglich.

Im Hinblick auf Löschzeiten unter 30 Sekunden ist es in dieser Speicherzelle vorteilhaft, die Dicke der ersten Siliziumoxidschicht und der zweiten Siliziumoxidschicht zwischen 3,2 nm und 4 nm vorzusehen.

Mit dem erfindungsgemäßen Verfahren können Speicherzellenanordnungen betrieben werden, die, wie allgemein üblich, matrixförmig eine Vielzahl identischer Speicherzellen aufweisen.

Die MOS-Transistoren in den Speicherzellen können sowohl als planare als auch als vertikale MOS-Transistoren ausgebildet werden.

Im folgenden wird die Erfindung anhand von Ausführungsbeispielen und der Figuren näher erläutert.
- Figur 1: zeigt eine Speicherzelle mit einem planaren MOS-Transistor mit einer Gateelektrode aus n-dotiertem Silizium.
- Figur 2: zeigt eine Speicherzelle mit einem planaren MOS-Transistor mit einer Gateelektrode aus p⁺-dotiertem Silizium.

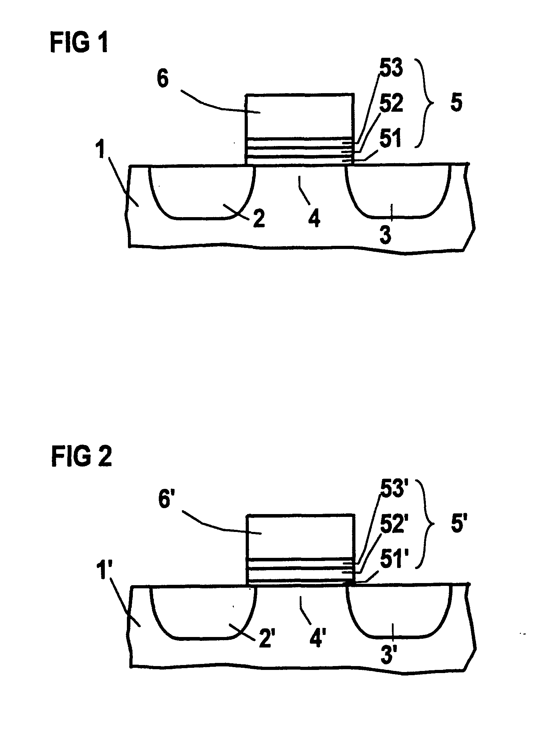

In einem Substrat 1, das mindestens im Bereich einer Speicherzelle monokristallines Silizium umfaßt, sind ein Sourcegebiet 2 und ein Draingebiet 3, die zum Beispiel n-dotiert sind, vorgesehen (siehe Figur 1). Zwischen dem Sourcegebiet 2 und dem Draingebiet 3 ist ein Kanalbereich 4 angeordnet. Sourcegebiet 2, Kanalbereich 4 und Draingebiet 3 sind zum Beispiel nebeneinander an der Oberfläche des Substrats 1 angeordnet. Alternativ können sie auch als vertikale Schichtenfolge angeordnet sein.

Oberhalb des Kanalbereichs 4 ist eine dielektrische Dreifachschicht angeordnet, die eine erste SiO₂-Schicht 51, eine Si₃N₄-Schicht 52 und eine zweite SiO₂-Schicht 53 umfaßt. Die erste SiO₂-Schicht 51 ist an der Oberfläche des Kanalbereichs 4 angeordnet und weist eine Dicke von 3 bis 6 nm, vorzugsweise 5 nm, auf. An der Oberfläche der ersten SiO₂-Schicht 51 ist die Si₃N₄-Schicht 52 angeordnet. Sie weist eine Dicke von mindestens 5 nm, vorzugsweise 8 nm, auf. An der Oberfläche der Si₃N₄-Schicht 52 ist die zweite SiO₂-Schicht 53 angeordnet, deren Dicke um 0,5 bis 1 nm größer als die Dicke der ersten SiO₂-Schicht 52 ist, das heißt im Bereich zwischen 3,5 und 6,5 nm, vorzugsweise bei 4,5 nm, liegt.

Auf der Oberfläche der dielektrischen Dreifachschicht 5 ist eine Gateelektrode 6 aus zum Beispiel n⁺-dotiertem Polysilizium angeordnet. Die Gateelektrode 6 weist eine Dicke von zum Beispiel 200 nm und eine Dotierstoffkonzentration von zum Beispiel 10²¹ cm⁻³ auf. Die Gateelektrode 6 kann alternativ auch aus Metall, zum Beispiel Aluminium, oder einem Metallsilizid, zum Beispiel TiSi₂, gebildet werden.

Zum Betrieb einer Speicherzellenanordnung mit einer Vielzahl identischer Speicherzellen, wie sie in Figur 1 dargestellt sind, wird die Information im Sinne einer Mehrwertlogik, zum Beispiel mit 2⁵ = 32 Werten, abgespeichert. Dazu werden in einem Einsatzspannungsfenster von zum Beispiel 3,2 Volt 32 Einsatzspannungspegel definiert. Beispielsweise gilt:

| Nummer des Einsatzspannungspegels | Einsatzspannungspegel (mV) |
|---|---|
| 0 | 400 |
| 1 | 442 |
| 2 | 488 |
| 3 | 538 |
| 4 | 592 |
| 5 | 650 |
| 6 | 712 |
| 7 | 778 |
| 8 | 848 |
| 9 | 922 |
| 10 | 1000 |
| 11 | 1082 |
| 12 | 1168 |
| 13 | 1258 |
| 14 | 1352 |
| 15 | 1450 |
| 16 | 1552 |
| 17 | 1658 |
| 18 | 1768 |
| 19 | 1882 |
| 20 | 2000 |
| 21 | 2122 |
| 22 | 2248 |
| 23 | 2378 |
| 24 | 2512 |
| 25 | 2650 |
| 26 | ' 2792 |
| 27 | 2938 |
| 28 | 3088 |
| 29 | 3242 |
| 30 | 3400 |
| 31 | 3562 |

Der Abstand zwischen benachbarten Einsatzspannungspegeln nimmt mit zunehmendem Einsatzspannungspegel zu. Bei den kleinsten Einsatzspannungspegeln um 0,4 Volt beträgt er 0,04 Volt, bei Einsatzspannungspegeln um 3,4 Volt beträgt er 0,15 Volt. Die zeitliche Drift des Einsatzspannungspegels über 10 Jahre beträgt bei einem anfänglichen Einsatzspannungspegel von 2 Volt 25 mV, bei einem anfänglichen Einsatzspannungspegel von 3,5 Volt 42 mV.

Zum Einschreiben der Information werden bei einer Schreibzeit von 1 ms Spannungspegel zwischen 11,5 Volt und 15,5 Volt an die Gateelektrode angelegt.

Zum Auslesen der Information kann einerseits der Einsatzspannungspegel der Speicherzelle bewertet werden. Andererseits kann die Abhängigkeit des über den Transistor fließenden Stroms von einer an der Gateelektrode anliegenden Steuerspannung bewertet werden.

In einem Substrat 1', das mindestens im Bereich einer Speicherzelle monokristallines Silizium umfaßt, sind ein Sourcegebiet 2' und ein Draingebiet 3', die zum Beispiel n-dotiert sind, vorgesehen (siehe Figur 2). Zwischen dem Sourcegebiet 2' und dem Draingebiet 3' ist ein Kanalbereich 4' angeordnet. Sourcegebiet 2', Kanalbereich 4' und Draingebiet 3' sind zum - Beispiel nebeneinander an der Oberfläche des Substrats 1' angeordnet. Alternativ können sie auch als vertikale Schichtenfolge angeordnet sein.

Oberhalb des Kanalbereichs 4' ist eine dielektrische Dreifachschicht angeordnet, die eine erste SiO₂-Schicht 51', eine Si₃N₄-Schicht 52' und eine zweite SiO₂-Schicht 53' umfaßt. Die erste SiO₂-Schicht 51' ist an der Oberfläche des Kanalbereichs 4' angeordnet und weist eine Dicke von 3,2 bis 4 nm, vorzugsweise 3,5 nm, auf. An der Oberfläche der ersten SiO₂-Schicht 51' ist die Si₃N₄-Schicht 52' angeordnet. Sie weist eine Dicke von mindestens 5 nm, vorzugsweise 8 nm, auf. An der Oberfläche der Si₃N₄-Schicht 52' ist die zweite SiO₂-Schicht 53' angeordnet, deren Dicke Bereich zwischen 3,5 und 6,5 nm, vorzugsweise bei 4,5 nm, liegt.

Auf der Oberfläche der dielektrischen Dreifachschicht 5' ist eine Gateelektrode 6' aus zum Beispiel p⁺-dotiertem Polysilizium angeordnet. Die Gateelektrode 6' weist eine Dicke von zum Beispiel 200 nm und eine Dotierstoffkonzentration von zum Beispiel 5 x 10²⁰ cm⁻³ auf.

Zum Betrieb einer Speicherzellenanordnung mit einer Vielzahl identischer Speicherzellen, wie sie in Figur 2 dargestellt sind, wird die Information im Sinne einer Mehrwertlogik, zum Beispiel mit 2² = 4 Werten, abgespeichert. Dazu werden in einem Einsatzspannungsfenster von zum Beispiel 4 Volt 4 Einsatzspannungspegel definiert. Beispielsweise gilt:

| Nummer des Einsatzspannungspegels | Einsatzspannungspegel (Volt) | zeitliche Drift in 10 Jahren (mV) |
|---|---|---|
| 0 | 0,0 | +50 |
| 1 | 1,0 | -100 |
| 2 | 2,0 | -400 |
| 3 | 3,5 | -1000 |

Der Abstand zwischen benachbarten Einsatzspannungspegeln nimmt mit zunehmendem Abstand des Einsatzspannungspegels von dem Einsatzspannungswert, den der MOS-Transistor ohne in der Siliziumnitridschicht gespeicherte Ladung aufweist, zu. Bei den kleinsten Abständen der Einsatzspannungspegel von dem Einsatzspannungswert, den der MOS-Transistor ohne in der Siliziumnitridschicht gespeicherte Ladung aufweist, um 0,5 Volt beträgt er 1,0 Volt, bei Abständen der Einsatzspannungspegel von dem Einsatzspannungswert, den der MOS-Transistor ohne in der Siliziumnitridschicht gespeicherte Ladung aufweist, um 3 Volt beträgt er 1,5 Volt. Die zeitliche Drift des Einsatzspannungspegels über 10 Jahre beträgt bei einem anfänglichen Einsatzspannungspegel von 3,5 Volt -1000 mV, bei einem anfänglichen Einsatzspannungspegel von 0 Volt 50 mV.

Zum Einschreiben der Information in eine Speicherzelle im Ausgangszustand mit einer Schreibzeit von 1 ms werden Spannungspegel zwischen +10 Volt und +14 Volt an die Gateelektrode angelegt.

Zum Auslesen der Information kann einerseits der Einsatzspannungspegel der Speicherzelle bewertet werden. Andererseits kann die Abhängigkeit des über den Transistor fließenden Stroms von einer an der Gateelektrode anliegenden Steuerspannung bewertet werden.

## Patentansprüche

1. Verfahren zum Betrieb einer Speicherzellenanordnung,
- bei dem als Speicherzellen MOS-Transistoren verwendet werden, die als Gatedielektrikum eine dielektrische Dreifachschicht (5) mit einer Siliziumoxidschicht (51), einer Siliziumnitridschicht (52) und einer zweiten Siliziumoxidschicht (53) umfassen, wobei die erste Siliziumoxidschicht (51) und die zweite Siliziumoxidschicht (53) jeweils mindestens 3 nm dick sind,
- bei dem zur Speicherung von Information eine Mehrwertlogik mit mehr als zwei logischen Werten verwendet wird, wobei zum Einschreiben der logischen Werte in eine der Speicherzellen jeweils eine dem logischen Wert zugeordnete Ladungsmenge durch Fowler-Nordheim-Tunneln auf das Gatedielektrikum aufgebracht wird und im Gatedielektrikum gespeichert wird, die einen dem logischen Wert zugeordneten Einsatzspannungspegel des MOS-Transistors bewirkt.

2. Verfahren nach Anspruch 1,
bei dem der Abstand zwischen benachbarten Einsatzspannungspegeln mit zunehmendem Einsatzspannungspegel zunimmt.

3. Verfahren nach Anspruch 1 oder 2,
- bei dem die Differenz der Dicken der ersten Siliziumoxidschicht (51) und der zweiten Siliziumoxidschicht (53) im Bereich zwischen 0,5 nm und 1 nm liegt,
- bei dem die geringere der Dicken der ersten Siliziumoxidschicht (51) und der zweiten Siliziumoxidschicht (53) im Bereich zwischen 3 und 6 nm liegt,
- bei dem die Dicke der Siliziumnitridschicht (52) mindestens 5 nm beträgt,
- bei dem der MOS-Transistor jeweils eine Gateelektrode (6) aus n-dotiertem Silizium umfaßt.

4. Verfahren nach Anspruch 3,
bei dem eine Mehrwertlogik mit 2ⁿ Werten verwendet wird, wobei n zwischen 2 und 6 liegt.

5. Verfahren nach Anspruch 1 oder 2,
- bei dem die Differenz der Dicken der ersten Siliziumoxidschicht (51') und der zweiten Siliziumoxidschicht (53') im Bereich zwischen 0,5 nm und 1 nm liegt,
- bei dem die geringere der Dicken der ersten Siliziumoxidschicht (51') und der zweiten Siliziumoxidschicht (53') im Bereich zwischen 3,2 und 4 nm liegt,
- bei dem die Dicke der Siliziumnitridschicht (52') mindestens 5 nm beträgt,
- bei dem der MOS-Transistor jeweils eine Gateelektrode (6') aus p⁺-dotiertem Silizium umfaßt.

6. Verfahren nach Anspruch 5,
bei dem das p⁺-dotierte Silizium in der Gateelektrode (6') eine Dotierstoffkonzentration von mindestens 1 x 10²⁰ cm⁻³ aufweist.

7. Verfahren nach Anspruch 5 oder 6,
bei dem eine Mehrwertlogik mit 2ⁿ Werten verwendet wird, wobei n zwischen 2 und 3 liegt.

## Claims

1. Method for operating a memory cell arrangement,
- in which the memory cells used are MOS transistors comprising, as gate dielectric, a dielectric triple layer (5) having a silicon oxide layer (51), a silicon nitride layer (52) and a second silicon oxide layer (53), the first silicon oxide layer (51) and the second silicon oxide layer (53) each having a thickness of at least 3 nm,
- in which multi-value logic with more than two logic values is used in order to store information, in which case, in order to write the logic values to one of the memory cells, a respective quantity of charge assigned to the logic value is applied to the gate dielectric by Fowler-Nordheim tunnelling and is stored in the gate dielectric, which quantity of charge effects a threshold voltage level of the MOS transistor which is assigned to the logic value.

2. Method according to Claim 1,
in which the amount separating neighbouring threshold voltage levels increases as the threshold voltage level increases.

3. Method according to Claim 1 or 2,
- in which the difference between the thicknesses of the first silicon oxide layer (51) and the second silicon oxide layer (53) lies in the range between 0.5 nm and 1 nm,
- in which the smaller of the thicknesses of the first silicon oxide layer (51) and of the second silicon oxide layer (53) lies in the range between 3 and 6 nm,
- in which the silicon nitride layer (52) has a thickness of at least 5 nm,
- in which the MOS transistor in each case comprises a gate electrode (6) made of n-doped silicon.

4. Method according to Claim 3,
in which multi-value logic with 2ⁿ values is used, where n is between 2 and 6.

5. Method according to Claim 1 or 2,
- in which the difference between the thicknesses of the first silicon oxide layer (51') and the second silicon oxide layer (53') lies in the range between 0.5 nm and 1 nm,
- in which the smaller of the thicknesses of the first silicon oxide layer (51') and of the second silicon oxide layer (53') lies in the range between 3.2 and 4 nm,
- in which the silicon nitride layer (52') has a thickness of at least 5 nm,
- in which the MOS transistor in each case comprises a gate electrode (6') made of p⁺-doped silicon.

6. Method according to Claim 5,
in which the p⁺-doped silicon in the gate electrode (6') has a dopant concentration of at least 1 H 10²⁰ cm⁻³.

7. Method according to Claim 5 or 6,
in which multi-value logic with 2ⁿ values is used, where n is between 2 and 3.

## Revendications

1. Procédé pour faire fonctionner un dispositif à cellules de mémoire,
- dans lequel on utilise comme cellules de mémoire des transistors MOS qui comprennent comme diélectrique de grille une couche (5) diélectrique triple ayant une couche (51) d'oxyde de silicium, une couche (52) de nitrure de silicium et une seconde couche (53) d'oxyde de silicium, la première couche (51) d'oxyde de silicium et la seconde couche (53) d'oxyde de silicium ayant respectivement une épaisseur d'au moins 3 nm,
- dans lequel on utilise pour mémoriser de l'information une logique à plusieurs valeurs ayant plus de deux valeurs logiques en appliquant, pour l'écriture des valeurs logiques dans l'une des cellules de mémoire respectivement une quantité de charge associée à la valeur logique par effet tunnel Fowler-Nordheim au diélectrique de grille et en l'emmagasinant dans le diélectrique, cette quantité donnant au transistor MOS un niveau de tension de coupure associé à la valeur logique.

2. Procédé suivant la revendication 1,
dans lequel l'intervalle entre deux niveaux voisins de tension de coupure augmente au fur et à mesure qu'augmente le niveau de la tension de coupure.

3. Procédé suivant la revendication 1 ou 2,
- dans lequel la différence des épaisseurs de la première couche (51) d'oxyde de silicium et de la seconde couche (53) d'oxyde de silicium est comprise entre environ 0,5 nm et 1 nm,
- dans lequel la plus petite des épaisseurs de la première couche (51) d'oxyde de silicium et de la seconde couche (53) d'oxyde de silicium est comprise entre environ 3 et 6 nm,
- dans lequel l'épaisseur de la couche (52) de nitrure de silicium est d'au moins 5 nm,
- dans lequel le transistor MOS comporte respectivement une électrode (6) de grille en silicium à dopage n.

4. Procédé suivant la revendication 3,
dans lequel on utilise une logique à plusieurs valeurs ayant 2ⁿ valeurs, n étant compris entre 2 et 6.

5. Procédé suivant la revendication 1 ou 2,
- dans lequel la différence entre l'épaisseur de la première couche (51') d'oxyde de silicium et celle de la seconde couche (53') d'oxyde de silicium est comprise entre environ 0,5 nm et 1 nm,
- dans lequel la plus petite des épaisseurs de la première couche (51') d'oxyde de silicium et de la seconde couche (53') d'oxyde de silicium est comprise entre environ 3,2 et 4 nm,
- dans lequel l'épaisseur de la couche (52') de nitrure de silicium est d'au moins 5 nm,
- dans lequel le transistor MOS comporte respectivement une électrode (6') de grille en silicium à dopage p+.

6. Procédé suivant la revendication 5,
dans lequel le silicium à dopage p+ de l'électrode (6') de grille a une concentration de substance de dopage d'au mois 1 x 10²⁰ cm⁻³.

7. Procédé suivant la revendication 5 ou 6,
dans lequel on utilise une logique à plusieurs valeurs ayant 2ⁿ valeurs, n étant compris entre 2 et 3.
